# EUROPÄISCHE PATENTSCHRIFT

(11) **EP 2 812 459 B1**
(45) Veröffentlichungstag und Bekanntmachung des Hinweises auf die Patenterteilung: **15.06.2016**
(21) Anmeldenummer: 12812533.3
(22) Anmeldetag: 21.12.2012
(51) Int. Cl.: C23C 4/04, G06F 17/50, C23C 4/00, F02F 1/20, G01B 21/20, G01B 21/30

(54) **THERMISCH BESCHICHTETES BAUTEIL MIT EINER REIBUNGSOPTIMIERTEN LAUFBAHNOBERFLÄCHE**
THERMALLY COATED COMPONENT WITH A FRICTIONALLY OPTIMIZED RUNWAY SURFACE
PIÈCE À REVÊTEMENT THERMIQUE DOTÉE D'UNE SURFACE DE GLISSEMENT À FROTTEMENT OPTIMISÉ

(30) Priorität: 11.02.2012 DE 102012002766
(43) Veröffentlichungstag der Anmeldung: 17.12.2014
(73) Patentinhaber: Daimler AG, 70327 Stuttgart (DE)
(72) Erfinder: BOEHM, Jens, 73765 Neuhausen (DE); HARTWEG, Martin, 89155 Erbach (DE); HERCKE, Tobias, 71111 Waldenbuch (DE); IZQUIERDO, Patrick, 89075 Ulm (DE); MICHEL, Manuel, 73765 Neuhausen a.d.F. (DE); RAU, Günter, 71686 Remseck (DE); SCHWEICKERT, Stefan, 73207 Plochingen (DE)
(74) Vertreter: JENSEN & SON
(86) Internationale Anmeldenummer: PCT/EP2012/005344
(87) Internationale Veröffentlichungsnummer: WO 2013/117209

(56) Entgegenhaltungen:
- EP-A1- 1 559 807
- DE-A1-102007 008 604
- DE-A1-102009 022 177
- DE-B3- 10 308 422
- DE-C1- 19 806 689

## Beschreibung

Die Erfindung betrifft ein thermisch beschichtetes Bauteil mit einer reibungsoptimierten Laufbahnoberfläche für einen Reibungspartner.

Aus dem Stand der Technik ist es bekannt, die Oberflächeneigenschaften wie z.B. die Reibung von Bauteilen, die mit einem Reibungspartner zusammenwirken, zu optimieren. Bauteile dieser Art sind etwa die Paarung Zylinder und Kolben, deren Zusammenwirkung von höchster Relevanz im Hinblick auf die Gesamtleistung eines Verbrennungsmotors insbesondere auch aus ökologischer und ökonomischer Sicht ist. Der Ölverbrauch eines Verbrennungsmotors bestimmt sich wesentlich durch die Reibung, die durch mechanische Oberflächenbearbeitung zur Einbringung Öl-rückhaltender Strukturen verringert werden kann. Als Verfahren zur Behandlung kommen spanende Methoden wie das Honen, insbesondere das Laserhonen und das Spiralgleithonen in Frage. So werden Mikrostrukturen als "Taschen" eingebracht, in denen sich das Öl sammelt und einen Fluidfilm bildet, der den Reibungspartner quasi aufschwimmen lässt und damit die Reibung ideal verringert.

Die Oberflächen solcher oberflächenbearbeiteter Bauteile, die mit einem Reibungspartner zusammenwirken, weisen häufig außerdem werkstoffspezifische Strukturen auf, die etwa bei der Fertigung einer Beschichtung der Oberfläche entstehen und die durchaus unerwünscht sein können, und bearbeitungsspezifische Strukturen, die der Oberflächenbehandlung auf die gewünschte Weise zuträglich sind. So kann es sich erweisen, dass ein scheinbar oberflächenoptimiertes Bauteil nicht die erwarteten Reibeigenschaften zeigt.

Aus den Druckschriften DE 102010049840 A1, DE 102009010790 A1, DE 19628786 A1, DE 10308422 B3, DE 19806689 C1, DE 102009022177A1 und DE 102007008604 A1 sind gattungsgemäße thermisch beschichtete Bauteile bekannt.

Ausgehend von diesem Stand der Technik ist es Aufgabe der vorliegenden Erfindung, verbesserte thermisch beschichtete Bauteile mit reibungsoptimierter Oberfläche einer Laufbahn für einen Reibungspartner zu schaffen, die ein reproduzierbares und möglichst vorbestimmbares Ölhaltevolumen aufweisen, um die gewünschten Laufeigenschaften der Reibungspartner zu leisten.

Diese Aufgabe wird durch ein thermisch beschichtetes Bauteil mit den Merkmalen des Anspruchs 1 gelöst, das eine reibungsoptimierten Oberfläche einer Laufbahn für einen Reibungspartner aufweist.

Weiterbildungen des Bauteils sind in den Unteransprüchen ausgeführt.

Weiter ergibt sich die Aufgabe, ein Verfahren zur Bauteil-Beschichtungsoberflächensimulation eines thermisch beschichteten Bauteils zu schaffen, das eine reibungsoptimierte Oberfläche einer Laufbahn für einen Reibungspartner aufweist.

Ein solches Verfahren wird durch das Verfahren mit den Merkmalen des Anspruchs 6 zur Verfügung gestellt.

Das erfindungsgemäße thermisch beschichtete Bauteil hat eine reibungsoptimierte Oberfläche einer Laufbahn für einen Reibungspartner, die ein Ölhaltevolumen V_{Öl} von 10 bis 800 µm³/mm² aufweist.

Das Ölhaltevolumen V_{Öl} muss über die Laufbahnlänge und/oder deren Umfang nicht konstant sein. Ölhaltevolumen V_{Öl} setzt sich Ölhaltevolumen der reibungsoptimierten Bearbeitungsstruktur V_{Öl,Bearbeitung} und dem Ölhaltevolumen von Poren V_{Öl,Poren} zusammen.

In bevorzugter Ausgestaltung weist die reibungsoptimierte Oberfläche der Laufbahn, die ein Ölhaltevolumen V_{Öl} von 50 bis 200 µm³/mm² auf.

Vorteilhaft ist das Ölhaltevolumen ein durch eine Bauteil-Beschichtungsoberflächensimulation vorbestimmbares theoretisches Ölhaltevolumen.

Die Oberflächenbehandlung der reibungsoptimierte Oberfläche kann vorteilhaft eine mechanische, insbesondere spanende Bearbeitung sein. Dabei kommen Honbearbeitungsverfahren in Frage, die dem Fachmann an sich bekannt sind und die sich hochpräzise ausführen lassen; auch an Oberflächen, wie erfindungsgemäß bevorzugt, die thermische Spritzschichten, insbesondere durch Lichtbogendrahtspritzen oder durch das PTWA-Spritzverfahren (Phase Transfer Wire Arc Spray Coating) erhaltene Beschichtungen sind.

Das erfindungsgemäße Bauteil kann ein Zylinderkurbelgehäuse oder ein Kolben sein, oder ein Pleuel oder eine Buchse wie eine Zylinderlaufbuchse, nur um einige Bauteile zu nennen; es kann grundsätzlich jede Form haben, die in einem oder in der ein Reibungspartner unter Ölschmierung reibungsarm laufen soll.

Vorteilhaft kann erfindungsgemäß das theoretische Ölhaltevolumen V_{Öl}, das bei 10 bis 800 µm³/mm² liegen soll, besonders bevorzugt bei 50 bis 200 µm³/mm² liegen soll, mittels einer Bauteil-Beschichtungsoberflächensimulation vorbestimmt werden.

Eine solche Simulation dient der funktionsbezogenen, einfachen, detaillierten und reibungspartnerbezogenen Bewertung von Oberflächen.

In einer ersten Ausführungsform des Simulationsverfahrens erfolgt daher die Kenngrößenbestimmung von Oberflächenstrukturen einer Bauteil-Beschichtungsoberfläche, die in Wirkverbindung mit einem Reibungspartner stehen. Die Kenngröße simuliert dabei eine Funktion zwischen der Bauteil-Beschichtungsoberfläche und dem Reibungspartner. Das Verfahren erlaubt daher unter Heranziehen der Kenngrößen mittels softwaretechnisch einfacher Modelle das Funktionsverhalten von Bauteil-Beschichtungsoberflächen zu simulieren. So ergibt sich durch das erfindungsgemäße Verfahren die Möglichkeit, funktionsbezogene Toleranzen in Abhängigkeit vom Reibungspartner der zu bewertenden Oberfläche zu schaffen und so das Zusammenspiel zwischen den Kontaktpartnern zu optimieren.

Das Verfahren umfasst die folgenden Schritte:
Zunächst wird mittels eines Profiltiefenbestimmungsverfahrens die Gesamtheit der Oberflächenstrukturen zumindest eines vorbestimmten Abschnitts der Oberfläche des Werkstoffs erfasst. Sie wird als Gesamtprofil dargestellt, wobei das Gesamtprofil als Datensatz von entlang einer Schnittlinie erhaltenen Profiltiefenwerten um eine vorbestimmte Mess-Grundlinie, die jeweils einer Position entlang der Länge der Mess-Grundlinie zugeordnet werden, aufgenommen wird. Es wird sodann ein mathematisch - morphologisches Berechnungsprogramm auf den Datensatz des Gesamtprofils angewendet und dabei das Abrollen eines Kreises mit einem definierten Radius auf dem Gesamtprofil simuliert und eine Abrolllinie über dem Gesamtprofil erhalten, die einen Konturablauf des Kontaktpartners auf der Werkstoffoberfläche simuliert. Nun folgt das Berechnen oder Integrieren einer von der Abrolllinie und dem Gesamtprofil begrenzten Gesamtfläche, und das Festlegen der Gesamtfläche als eine erste Kenngröße.

In einer Weiterbildung des Verfahrens wird mit der ersten Kenngröße eine zweite Kenngröße bestimmt. Das umfasst das Projizieren der Gesamtfläche in die dritte Dimension in Bezug zu der Werkstoffoberfläche und Berechnen eines Gesamtvolumens als die zweite Kenngröße.

In noch einer Weiterbildung umfasst das Berechnen der Gesamtfläche das Bestimmen einer Differenz zu der Abrolllinie für jeden Profiltiefenwert und das Bestimmen einer Einzelfläche zwischen jedem Profiltiefenwert und einem entsprechenden Abschnitt der Abrolllinie als Funktion der Position des Profiltiefenwerts entlang der Schnittlinie. Dann werden die Einzelflächen entlang der Schnittlinie aufaddiert.

Ferner kann die erste Kenngröße streckenbezogen normiert werden und die zweite Kenngröße kann flächenbezogen normiert werden. Dies dient vorteilhaft zur Grundlagenschaffung für Vergleiche etc. bei verschieden langen Profilschnitten.

So kann die funktionssimulierende erste Kenngröße ein Maß für die zur Schmierung relevante Ölmenge sein und die daraus projizierte zweite Kenngröße ein theoretisches Ölhaltevolumen der Bauteil-Beschichtungsoberfläche angeben. Der definierte Radius des Kreises zur Bestimmung der Abrolllinie, die beispielsweise einer theoretischen Ablaufkontur des Kolbenrings entspricht, kann hierfür etwa 100 mm betragen.

Es können weitere Kenngrößen bestimmt werden, wie bspw. das Deckel-Ölvolumen, insbesondere der Porenanteil, die mittlere Porenbreite, die mittlere Porenschnittfläche aus dem Porenprofil.

Generell bilden die Bauteil-Beschichtungsoberfläche und der Reibungspartner ein statisches Dichtheitssystem, insbesondere entlang einer Dichtsicke von Kopfdichtungen an Trennflächen von Kurbelgehäuse und Zylinderkopf, wobei hier die funktionssimulierende erste Kenngröße einen theoretischen Dichtspalt angibt. Der definierte Radius des Kreises zur Bestimmung der Abrolllinie, die einem theoretischen Konturablauf der Dichtsicke entspricht, kann dann zur Anpassung an verschiedene Dichtungsausführungen und -beanspruchungen gewählt werden; er kann etwa im Bereich von 1 mm bis 100 mm liegen.

Ferner können weitere Kenngrößen bestimmt werden, insbesondere eine größte Einzelspaltfläche.

Durch Anwendung des Verfahrens können Toleranzen für die funktionssimulierenden Kenngrößen in technischen Produktdokumentationen angegeben werden und es können Verfahrensanweisungen für Überschreitungen vorgesehen werden. Als Verfahren zur Bestimmung der Profiltiefe kommen insbesondere ein optisches Profilmessverfahren oder ein Tastschnittverfahren, insbesondere ein Tastschnittverfahren nach ISO 3274 in Frage.

Weiter kann das Simulationsverfahren das Bestimmen der Kenngrößen für bearbeitungs- und werkstoffspezifisch zu differenzierende Oberflächenstrukturen umfassen. Dabei wird das Gesamtprofil der Bauteil-Beschichtungsoberfläche in ein werkstoffspezifisches Porenprofil und ein Bearbeitungsprofil separiert. Die aus dem Stand der Technik bekannten Untersuchungs- und Oberflächenbewertungsverfahren bewerten die Oberflächen von Bauteilen, wie thermische Spritzschichten der erfindungsgemäßen Bauteile, etwa einer Lauffläche eines Zylinderkolbens, gesamtheitlich und damit ist keine Zuordnung von Merkmalsausprägungen zum Verursacher, etwa einem Bearbeiter oder Beschichter, möglich, wie sie gerade die erfindungsgemäßen Bauteiloberflächen aufweisen. Diese haben mehrere Herstellungs- und/oder Bearbeitungsschritte durchlaufen, um ihre endgültige Oberflächenbeschaffenheit zu erhalten. Daher sollen mit einem erfindungsgemäßen Differenzierungsverfahren zur Differenzierung technischer Oberflächenstrukturen herkunftspezifisch die Anteile an Oberflächenstrukturen bestimmt werden.

Die Differenzierung der Oberflächenstrukturen des mit einem Oberflächenbearbeitungsverfahren bearbeiteten Bauteils mit werkstoffinhärenten Oberflächenrauhigkeiten, etwa einer gehonten Beschichtung einer Kolbenlauffläche eines Zylinders, erfolgt so:
Um den Entstehungsgrund bzw. die Ursache der Strukturen nach ihrer Art feststellen zu können, wird Apriori-Wissen zu Grunde gelegt, damit die Strukturanteile voneinander separiert werden können. Danach können die voneinander separierten Strukturanteile unterschiedlichen Bewertungen zugeführt werden.

Dazu wird nach Durchführung eines Profiltiefenbestimmungsverfahrens die Gesamtheit der Oberflächenstrukturen eines Abschnitts der Beschichtungsoberfläche des Bauteils mit werkstoffinhärenten Oberflächenrauhigkeiten erfasst und als Gesamtprofil dargestellt.

Das Gesamtprofil wird als Datensatz von entlang einer Schnittlinie erhaltenen Profiltiefenwerten um eine vorbestimmte Mess-Grundlinie aufgenommen.

Dann wird mit demselben Profiltiefenbestimmungsverfahren die Gesamtheit der Oberflächenstrukturen eines Abschnitts der Oberfläche eines oberflächenbearbeiteten technischen Bauteils, der keine werkstoffinhärenten Oberflächenrauhigkeiten aufweist, erfasst, und als Bearbeitungsprofil dargestellt. Dieses wird als Datensatz entlang einer Schnittlinie erhaltener Profiltiefenwerte um eine vorbestimmte Mess-Grundlinie, die jeweils einer Position entlang der Länge der Mess-Grundlinie zugeordnet werden, aufgenommen.

Es folgt das Ermitteln einer für das Oberflächenbearbeitungsverfahren charakteristischen Schiefe der Häufigkeitsverteilung aller Bearbeitungsprofil-Tiefenwerte und das Definieren dieser Schiefe als charakteristische Soll-Schiefe für das Oberflächenbearbeitungsverfahren.

Weiter wird eine Start-Linie in dem Gesamtprofil bestimmt, die parallel zu der Mess-Grundlinie des Gesamtprofils entsprechend dem tiefsten Profiltiefenwert verläuft, und es wird eine erste Schiefe der Häufigkeitsverteilung der von der Startlinie tangierten Profiltiefenwerte des Gesamtprofils an der Startlinie ermittelt. Dann werden schrittweise voneinander beabstandete Zwischenlinien zwischen der Start-Linie und der Mess-Grundlinie definiert und, ausgehend von der Startlinie, sukzessive auch die Schiefen der Häufigkeitsverteilungen der von den entsprechenden Zwischenlinien tangierten Profiltiefenwerte des Gesamtprofils ermittelt.

Von der Startlinie ausgehend werden die ermittelten Schiefen mit der Sollschiefe verglichen. Bei Übereinstimmen der Schiefe einer bestimmten Zwischenlinie des Gesamtprofils mit der Soll-Schiefe werden alle Profiltiefenwerte ausgewählt, die diese bestimmte Zwischenlinie tangieren. Dann werden diese Profiltiefenwerte als ein Porenprofil dargestellt. Durch das Selektieren ergibt sich, dass das durch das Bearbeitungsverfahren entstandene "Bearbeitungsprofil" übrig bleibt und insofern vom Gesamtprofil separiert wird.

So wird die Strukturseparation quasi durch Anwendung von Apriori-Wissen ermöglicht, das erlangt wird, wenn ein Bauteil, das keine werkstoffinhärenten Oberflächenrauhigkeiten aufweist, demselben Bearbeitungsverfahren unterzogen wird wie ein Bauteil mit Oberflächenrauhigkeiten. Es wird beispielsweise untersucht, welche Ausprägung eine Honstruktur in einem Bauteil ohne Poren hat und daraus wird die Separation der Honstruktur in einem Bauteil mit Poren abgeleitet. Das Verfahren ermöglicht so die getrennte und gezielte Bewertung von Oberflächenstrukturen mit Zuordnung zum Verursacher.

Die funktionssimulierende erste Kenngröße als Maß für die zur Schmierung relevante Ölmenge und die daraus projizierte zweite Kenngröße, die ein theoretisches Ölhaltevolumen der Werkstoffoberfläche angibt, kann so auch jeweils für Gesamt-, Poren- und Bearbeitungsprofil bestimmt werden.

Ferner kann in einer weiteren Ausführungsform des Verfahrens das zusammenhängende Darstellen des Porenprofils der selektierten Profiltiefenwerte erfolgen. Besonders deutlich stellt sich das Porenprofil dar, wenn es in einem von dem Maßstab der Messstrecke des Gesamtprofils abweichenden Maßstab, insbesondere einem vergrößerten Maßstab, abgebildet wird. Die Poren und somit Werkstoffunebenheiten oder -rauhigkeiten werden dann aneinander hängend gezeigt und ebenso das Bearbeitungsprofil.

Nach der Strukturseparation können aus dem Bearbeitungsprofilschnitt und/oder dem Porenprofilschnitt sowohl bereits international genormte Kenngrößen (wie z. B. Rz, Ra in µm, ISO 4287) als auch die funktionssimulierenden Kenngrößen ausgewertet und in dem vorstehenden Simulationsverfahren eingesetzt werden. Dabei werden die Algorithmen der Kenngrößen auf die digital vorliegenden strukturseparierten Datensätze von Bearbeitungsprofilschnitt und/oder Porenprofilschnitt angewendet.

Um eine gute Auflösung respektive Trennung der Werkstoff- und Bearbeitungsprofile zu bekommen, wird die Beabstandung der Zwischenlinien voneinander und zu der Start-Linie und der Mess-Grundlinie im Bereich von 1 nm bis 20 nm, bevorzugt im Bereich von 5 nm bis 15 nm, am meisten bevorzugt bei 10 nm liegen.

Die Figuren verdeutlichen das verwendete Simulations- und das Differenzierungsverfahren für Oberflächen schematisch:
Dabei zeigen:
   - Fig. 1: ein Messprofil einer bearbeiteten porenbehafteten Zylinderlaufbahnoberfläche mit der erfindungsgemäß erzeugten Abrolllinie, die einem theoretischen Konturablauf des Kolbenrings entspricht, zur Ermittlung eines theoretischen Gesamt-Ölhaltevolumens als Kenngröße,
   - Fig. 2: ein Messprofil einer Kurbelgehäuse/Zylinderkopfoberfläche mit der erfindungsgemäß erzeugten Abrolllinie, die einem theoretischen Konturablauf der Dichtsicke entspricht, zur Ermittlung eines theoretischen Dichtspalts als Kenngröße,
   - Fig. 3: den Gesamt-Profilschnitt einer bearbeiteten porenbehafteten Bauteil-Beschichtungsoberfläche entsprechend Fig. 1, sowie den hieraus separierten Bearbeitungs-Profilschnitt und den Poren-Profilschnitt zur Ermittlung weiterer Kenngrößen.
   - Fig. 4: den Gesamt-Profilschnitt aus Fig. 3.

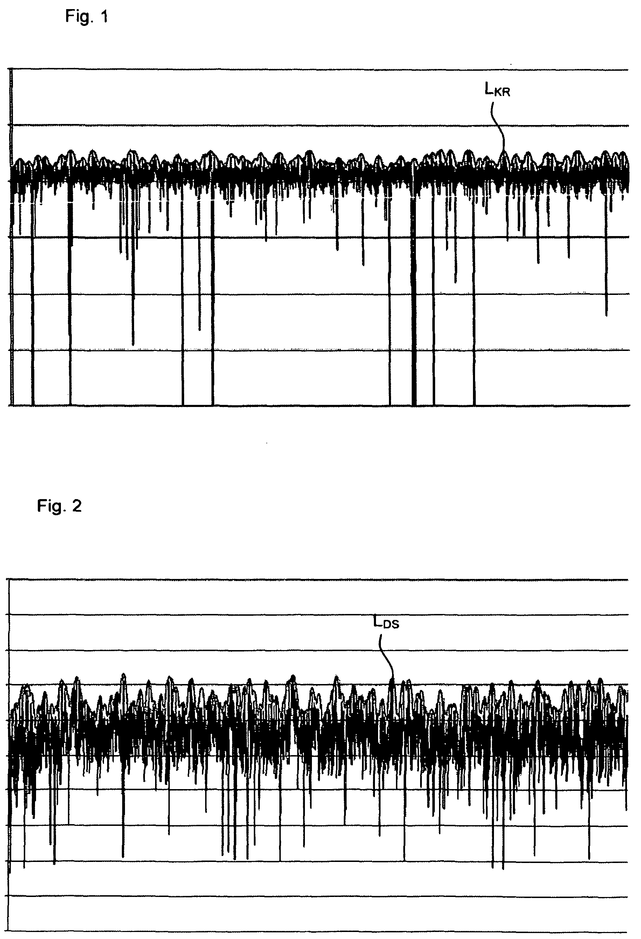

Das Simulationsverfahren dient der Ermittlung von Kenngrößen für Strukturen von Bauteil-Beschichtungsoberflächen, die mit einem Reibungspartner zusammenwirken, wie an zwei Beispielen verdeutlicht wird: Einmal wird die Ermittlung theoretischer Ölrückhaltevolumina und anderer funktionssimulierender Kenngrößen für die Bauteile Zylinderlaufbahn/Kolbenring an Hand Fig. 1 ausgeführt, und zum zweiten die Ermittlung eines theoretischen Dichtspalts und anderer funktionssimulierender Kenngrößen für statische Dichtheitssysteme (z.B. das Dichtverhalten entlang einer Dichtsicke von Kopfdichtungen an den Trennflächen eines Kurbelgehäuses und eines Zylinderkopfes) an Hand Fig. 2.

Fig. 1 verdeutlicht die Ermittlung der funktionssimulierenden Kenngrößen für das System Zylinderlaufbahn/Kolbenring. Die Differenz zwischen der theoretischen Ablaufkontur L_{KR} des Kolbenrings und dem an der Zylinderlaufbahn gemessenen Oberflächenprofil ist Basis für die Kenngrößen des "theoretischen Ölhaltevolumens nach Kolbenringsimulation".

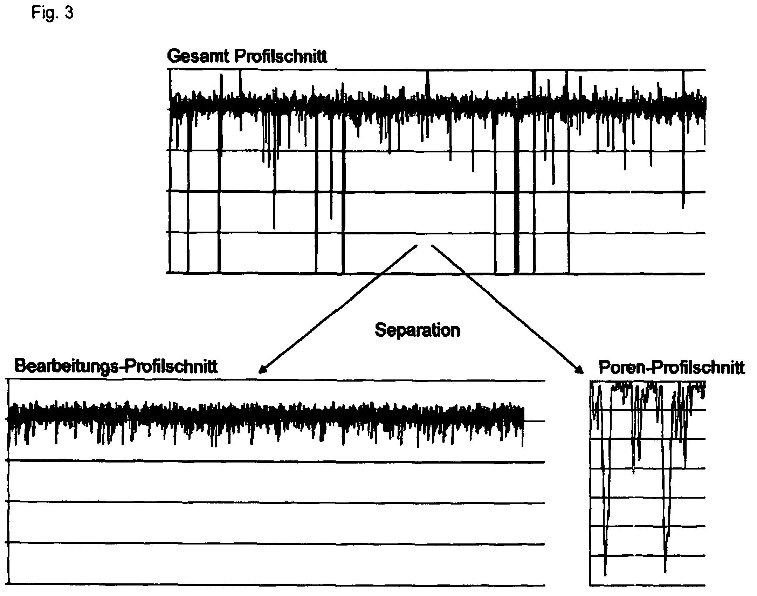

Hierzu bezeichnet V_{Öl,gesamt} in [µm²/mm³] das theoretische Ölhaltevolumen, das für das Gesamt-Profil ermittelt wurde, wie es in Fig. 1 zu sehen ist. Zur detaillierten Beurteilung können, wie in Fig. 3 zu sehen, die Oberflächenstrukturen des Gesamtprofils in ein Porenprofil und ein Bearbeitungsprofil separiert werden. Aus dem Bearbeitungsprofil kann ein theoretisches Ölhaltevolumen basierend auf Bearbeitungsstrukturen V_{Öl,Bearbeitung} (bei Honung der Lauffläche V_{Öl},_{Honung}) in [µm²/mm³] sowie aus dem Porenprofil ein auf den werkstoff- bzw. beschichtungsspezifischen Oberflächenstrukturen wie Poren basierendes theoretisches Ölhaltevolumen V_{Öl,Poren} in [µm²/mm³] ermittelt werden.

Weitere Kenngrößen, die insbesondere auch nach der Strukturseparation bestimmt werden können, sind ein Porenanteil [%], eine mittlere Porenbreite [µm] und eine mittlere Porenschnittfläche [µm²]. Eine Kenngröße V_{Öl,Deckel} [µm²/mm³] beschreibt ein theoretisches Ölhaltevolumen eines Deckels wie eines Zylinderdeckels, Zylinderkopfdeckel oder Ventildeckels.

Basis der Kenngrößenberechnung des bearbeitungsspezifischen theoretischen Ölhaltevolumens VÖl, Bearbeitung ist die Separation der Werkstoff- und bearbeitungsspezifischen Oberflächenstrukturen. V_{Öl,Bearbeitung} wird aus dem Bearbeitungsprofil (siehe Fig. 3) berechnet, das in axialer Richtung aufgezeichnet wird. Die Funktion des Kolbenringablaufs auf der Laufbahnoberfläche wird simuliert, indem auf den digitalen Datensatz des entsprechenden Profils, beispielsweise dem Gesamtprofil (Fig. 1) im Berechnungsprogramm ein mathematisch-morphologisches Verfahren angewendet wird, das das Abrollen eines Kreises mit definiertem Radius, hier 100 mm, auf dem Profil simuliert. Hierbei wird vorausgesetzt, dass die so erzeugte Abrolllinie L_{KR} ähnlich der Bewegungslinie des Kolbenrings an der Laufbahn ist. Der Spalt zwischen Abrolllinie L_{KR} und dem Oberflächenprofil ist ein Maß für die zur Schmierung bzw. für den Ölverbrauch relevante Ölmenge. Dieses Maß wird z.B. beim V_{Öl,Gesamt} aus der Aufsummierung aller Einzelspaltflächen als eine Gesamtfläche und darauffolgender Projektion in die dritte Dimension als Volumen berechnet. Um auch bei unterschiedlich langen Profilschnitten vergleichbare Ergebnisse zu bekommen, wird dieses berechnete Volumen auf 1 mm² normiert. Die Einheit von V_{Öl,Gesamt,} V_{Öl,Bearbeitung} und V_{Öl,Poren} beträgt µm³/mm².

V_{Öl,Bearbeitung} und V_{Öl,poren} werden genauso wie V_{Öl,Gesamt} ermittelt, V_{Öl,Poren} aber am Porenprofil und V_{Öl,Bearbeitung} am Bearbeitungsprofil, die wie Fig. 3 zeigt, die aus der Strukturseparierung des Gesamtprofils erhalten werden.

Fig. 3 zeigt die Trennung der durch den Bauteilwerkstoff bedingten Strukturen (Porenprofilschnitt) und den durch ein Bearbeitungsverfahren erzeugten Bearbeitungs-Profilschnitt aus einem Gesamt-Profilschnitt einer bearbeiteten porenbehafteten Bauteil-Beschichtungsoberfläche. Die separierten Profilschnitte können der Bewertung der Oberfläche für die erfindungsgemäß ermittelten Kenngrößen zugrunde gelegt werden. Der Profilschnitt der Oberfläche wird durch ein optisches Profilschnitt- oder vorzugsweise durch ein Tastschnittverfahren vermessen. Dabei werden die von einer Mess-Grundlinie abweichenden Profiltiefenwerte entlang einer Schnittlinie erfasst.

Bei mechanischen Tastschnittverfahren wird eine Tastspitze mit konstanter Geschwindigkeit über die bearbeitete Bauteil-Beschichtungsoberfläche verfahren. Das Messprofil ergibt sich aus den in Bezug zu der parallel zur Werkstückoberfläche verlaufenden Messgrundlinie vertikalen Lageverschiebungen der Tastspitze, die in der Regel durch ein induktives Wegmeßsystem erfasst werden. Dabei wird der Datensatz mit den Profiltiefenwerten entlang der Messlinie gewonnen.

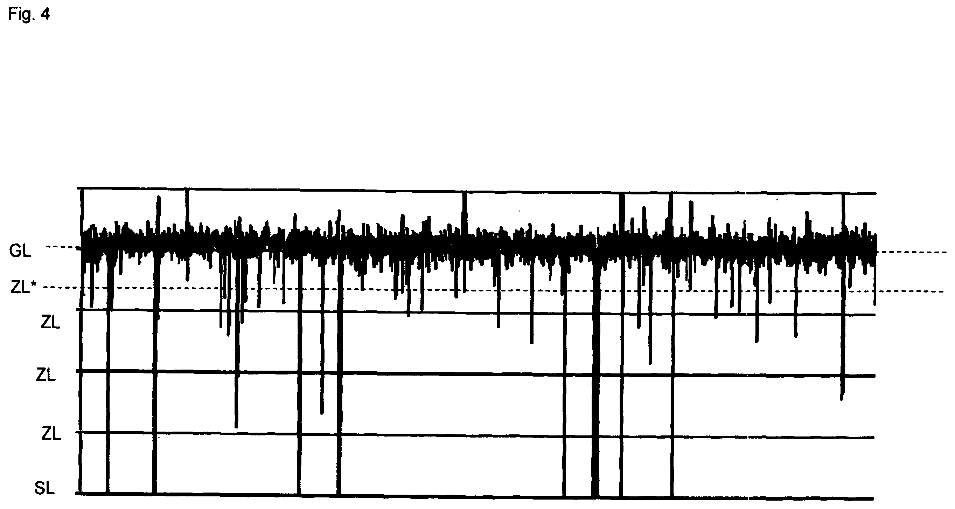

Das Oberflächendifferenzierungsverfahren, das in den Figuren 3 und 4 bildlich erläutert wird, macht es möglich, die durch den Werkstoff bedingten Strukturen von den durch ein Bearbeitungsverfahren erzeugten Oberflächenstrukturen zu separieren, was als Grundlage für die weitere Auswertung der Oberfläche dienen kann.

Als Basis zur Separierung Werkstoff- und bearbeitungsbedingter Oberflächenstrukturen werden zunächst Profilschnitte bzw. Messprofile von bearbeiteten Bauteiloberflächen gemacht, die keine Poren aufweisen und damit nur Bearbeitungsstrukturen zeigen. Daher kann ein solcher Profilschnitt als Apriori-Wissen herangezogen werden. Der erhaltene Datensatz mit den Profiltiefenwerten wird der Berechnung einer Schiefe der Häufigkeitsverteilung der Profiltiefenwerte zugrunde gelegt. Die Schiefe gibt die Neigungsstärke der statistischen Verteilung der Profiltiefenwerte an. Die mit dem porenlosen Bauteil ermittelte Schiefe ist charakteristisch für das jeweilige Bearbeitungsverfahren und beschreibt die Oberflächencharakteristik wie etwa symmetrische oder unterschiedlich stark plateauartige Strukturen unabhängig von der Höhenausprägung der Struktur, also unabhängig davon, ob grob oder fein bearbeitet wurde. Diese für das Bearbeitungsverfahren charakteristische Schiefe ist als Soll-Schiefe der entscheidende Parameter für die Strukturseparation.

Ein nach Erlangung des Apriori-Wissens an einer bearbeiteten Oberfläche eines porenbehafteten Werkstoffs durchgeführtes optisches oder Tastschnittverfahren ergibt den in Fig. 3 und Fig. 4 gezeigten Gesamt-Profilschnitt aus den entlang der Messlinie erfassten Profiltiefenwerten. Zur Durchführung der Separierung wird nun eine Startlinie SL definiert (vgl. Fig. 4), die parallel zu der Mess-Grundlinie GL an der tiefsten Stelle des Messprofils der porenbehafteten Werkstoffoberfläche vorliegt, also die tiefsten Profiltiefenwerte tangiert.

Schrittweise von der Startlinie SL ausgehend werden in Richtung der Mess-Grundlinie GL in vorbestimmten, vorzugsweise einstellbaren Schritten, beispielsweise von 10 nm, Zwischenlinien ZL definiert, wobei für jede Zwischenlinie ZL (gegebenenfalls auch für die Startlinie SL) die Schiefe der Häufigkeitsverteilung der Profiltiefenwerte ermittelt wird, die die jeweilige Zwischenlinie (bzw. Startlinie SL) tangieren. Unter "tangierende Profiltiefenwerte" sind vorliegend auch die Profiltiefenwerte gemeint, die die Zwischenlinie schneiden.

Die zu jeder Zwischenlinie ZL berechnete Schiefe wird mit der Soll-Schiefe verglichen. Bei der Zwischenlinie ZL*, deren Schiefe der Soll-Schiefe entspricht. werden alle Strukturtäler, also alle Profiltiefenwerte, die von der Zwischenlinie ZL* angeschnitten werden, von der Mess-Grundlinie GL ausgehend digital aus dem Gesamt-Profilschnitt selektiert und zusammenhängend in einem Poren-Profilschnitt dargestellt (vgl. Fig. 3). Hierbei verändert sich allerdings der Maßstab entlang der Messlinie. Der Poren-Profilschnitt gibt die Verteilung der Poren entlang der Messlinie wider und ist für den Werkstoff bzw. die Beschichtung typisch.

Das Gesamtprofil wird an den Stellen, an denen die Porenprofile entfernt wurden, zusammengeschoben, so dass sich der Bearbeitungs-Profilschnitt aus dem Gesamt-Profilschnitt wie in Fig. 3 dargestellt ergibt.

Das Separierungsverfahren kann automatisiert durch einen Computer mit entsprechenden Algorithmen ausgeführt werden, die die Ermittlung der Schiefen, Vergleich der Schiefen mit der Soll-Schiefe (die in einer Datenbank hinterlegt sein kann) und die "Aussortierung" der Profilabschnitte, die die Linie ZL* mit einer der Soll-Schiefe entsprechenden Schiefe schneiden, deren Zusammenfügung zum Poren-Profilschnitt und die Erstellung des Bearbeitungs-Profilschnitts ermöglichen.

Sowohl Poren-Profilschnitt als auch Bearbeitungs-Profilschnitt können der weiteren Auswertung der Oberfläche zugrunde gelegt werden. Dabei liegen der erhaltene Poren-Profilschnitt und der Bearbeitungs-Profilschnitt als Datensätze vor, die, wie in den Fig. 3 gezeigt, visuell dargestellt werden können und/oder zur Berechnung von Oberflächenkenngrößen herangezogen werden können.

Zwar führt die Oberflächenstrukturseparierung an sich nicht zur Bewertung der Oberflächenstrukturen, schafft jedoch die Vorraussetzung für eine sinnvolle Bewertung. Die Strukturseparierung kann wie oben beschrieben automatisiert ablaufen und insbesondere auch für verschiedene Bearbeitungsverfahren (durch die Ermittlung des entsprechenden Apriori-Wissens) angepasst werden. Dadurch wird die Basis zur Bewertung mit Parametern und Kenngrößen geschaffen. Anders als die bisher bekannten Daten-Vorverarbeitungsverfahren, wie z. B. der Filterung, führt das erfindungsgemäße Verfahren auch bei Oberflächen mit extremen Gegensätzen wie etwa einer sehr feine Bearbeitung bei Vorliegen von breiten und tiefen Poren nicht zu Fehlern, wie sie bislang durch die Überdeckung der Bearbeitungsstruktur bei stark ausgeprägten Poren auftraten, wodurch die Bewertung der Bearbeitungsstruktur mit Kenngrößen nahezu unmöglich war.

Weitere funktionssimulierende Kenngrößen sind die für statische Dichtheitssysteme relevanten Größen, etwa der theoretische Dichtspalt, der sich auf das Dichtverhalten entlang einer Dichtsicke von Kopfdichtungen an den Trennflächen von Kurbelgehäuse und Zylinderkopf bezieht. Der Dichtspalt wird am ungefilterten Oberflächen-Gesamtprofil ermittelt, indem auch hier die oben beschriebene Abrolllinie eines Kreises berechnet wird. Hierbei wird der Radius den Eigenschaften der Dichtung angepasst. So wird beispielsweise ein kleinerer Radius von etwa 1 mm bei mehreren Vollsicken und dicker Beschichtung der Metalllagenflachdichtung gewählt und ein entsprechend größerer Radius bei dünner Beschichtung. Der Spalt zwischen der berechneten Abrolllinie und dem Oberflächen-Gesamtprofil ist ein Maß für die zu erwartende Abdichtung. Der Dichtspalt, als Kenngröße Df bezeichnet, wird aus der Aufsummierung aller Einzelspaltflächen als eine Gesamtfläche in µm² berechnet. Um auch bei unterschiedlich langen Profilschnitten vergleichbare Ergebnisse zu bekommen, wird diese berechnete Fläche auf 1 mm normiert.

Eine weitere Kenngröße aus dieser Familie ist Dfmax in µm². Das ist die größte Einzelspaltfläche.

Für die Kenngrößenbestimmung der funktionssimulierenden Kenngrößen ist vorliegend keine Zwischenschaltung menschlicher Verstandestätigkeit erforderlich; das gesamte Bestimmungsverfahren läuft nach Eingabe der Messgrößen und Profile automatisch ab. Eine Besonderheit ist die Parametrisierbarkeit (Anpassungsfähigkeit) bei den Kenngrößen des theoretischen Dichtspaltes an verschiedene Dichtungsausführungen und Beanspruchungen.

Für alle funktionssimulierenden Kenngrößen können Toleranzen in technischen Produktdokumentationen angegeben werden. Wie bei Überschreitung verfahren wird, ist z. B. abhängig von den mitgelieferten Unterlagen wie etwa Verfahrensanweisungen.

In Fig. 2 entsprechen die Abstände der horizontalen Linien 1 µm, die Breite der dargestellten Messstrecke entspricht näherungsweise 12 mm. Gleiche Einheiten gelten für das Beispiel in Fig. 1, der V_{Öl,Gesam}-Darstellung. Es ist zu beachten, dass die Profile in Fig. 1 und 2 unterschiedliche Maßstäbe aufweisen.

Das Messprofil in Fig. 2 als Grundlage für die Bestimmung des Dichtspalts ist ein gemessenes, ungefiltertes Profil (Gesamt-Profil). Als Messverfahren kommen sowohl das Tastschnittverfahren (nach ISO 3274) als auch andere, z.B. optische Profilschnittverfahren in Frage. Simulationsverfahren erlaubt so die funktionsbezogene, einfache, detaillierte und reibungspartnerbezogene Bewertung von Oberflächen durch Kenngrößen, die softwaretechnisch in einfachen Modellen das Funktionsverhalten simulieren. Die Oberflächenbewertung erfolgt also in enger Korrelation zu Funktionseigenschaften in Abhängigkeit vom Reibungspartner. Alle bekannten Kenngrößen bewerten die betrachtete Oberfläche nur für sich ohne Reibungspartnerbezug.

## Patentansprüche

1. Thermisch beschichtetes Bauteil,
das eine reibungsoptimierte Oberfläche einer Laufbahn für einen Reibungspartner aufweist,
**dadurch gekennzeichnet, dass**
die reibungsoptimierte Oberfläche ein Ölhaltevolumen V_{Öl} von 10 bis 800 µm³/mm² aufweist.

2. Thermisch beschichtetes Bauteil nach Anspruch 1,
**dadurch gekennzeichnet, dass**
die reibungsoptimierte Oberfläche mechanisch bearbeitet, bevorzugt spanend bearbeitet, besonders bevorzugt honbearbeitet ist.

3. Thermisch beschichtetes Bauteil nach zumindest einem der Ansprüche 1 bis 2,
**dadurch gekennzeichnet, dass**
die thermische Beschichtung eine thermische Spritzschicht, bevorzugt eine durch Lichtbogendrahtspritzen oder durch das Plasma Transferred Wire Arc Spray Coating erhaltene Schicht ist.

4. Thermisch beschichtetes Bauteil nach zumindest einem der Ansprüche 1 bis 3,
**dadurch gekennzeichnet, dass**
das Bauteil ein Zylinderkurbelgehäuse oder ein Kolben, bevorzugt ein Pleuel, oder eine Buchse, bevorzugt eine Zylinderlaufbuchse ist.

5. Verfahren zur Bauteil-Beschichtungsoberflächensimulation eines thermisch beschichteten Bauteils, das eine reibungsoptimierte Oberfläche einer Laufbahn für einen Reibungspartner aufweist,
umfassend die Kenngrößenbestimmung für Oberflächenstrukturen der Bauteil-Beschichtungsoberfläche, wobei eine Kenngröße eine Funktion zwischen der Bauteil-Beschichtungsoberfläche und dem Reibungspartner simuliert, umfassend die Schritte:
- mit einem Profiltiefenbestimmungsverfahren Erfassen der Gesamtheit der Oberflächenstrukturen zumindest eines vorbestimmten Abschnitts der Oberfläche des Bauteils und Darstellen als Gesamtprofil, wobei das Gesamtprofil als Datensatz von entlang einer Schnittlinie erhaltenen Profiltiefenwerten um eine vorbestimmte Mess-Grundlinie, die jeweils einer Position entlang der Länge der Mess-Grundlinie zugeordnet werden, aufgenommen wird, und
- Anwenden eines mathematisch - morphologischen Berechnungsprogramms auf den Datensatz des Gesamtprofils, dabei Simulieren des Abrollens eines Kreises mit einem definierten Radius auf dem Gesamtprofil und Erhalten einer Abrolllinie (L_{KR,}L_{DS}) über dem Gesamtprofil, die einen Konturablauf des Reibungspartners auf der Bauteil-Beschichtungsoberfläche simuliert,
- Berechnen einer von der Abrolllinie (L_{KR,}L_{DS}) und dem Gesamtprofil begrenzten Gesamtfläche, und
- Festlegen der Gesamtfläche als eine erste Kenngröße,
- Projizieren der Gesamtfläche in die dritte Dimension in Bezug zu der Bauteil-Beschichtungsoberfläche und
- Berechnen eines Gesamtvolumens als eine zweite Kenngröße,
- Angabe der ersten Kenngröße als ein Maß für die zur Schmierung relevante Ölmenge und
- Angabe der zweiten Kenngrößen als ein theoretisches Ölhaltevolumen der Bauteil-Beschichtungsoberfläche.

6. Verfahren nach Anspruch 5,
wobei das Berechnen der Gesamtfläche umfasst:
- für jeden Profiltiefenwert Bestimmen einer Differenz zu der Abrolllinie und einer Einzelfläche zwischen jedem Profiltiefenwert und einem entsprechenden Abschnitt der Abrolllinie (L_{KR,}L_{DS}) als Funktion der Position des Profiltiefenwerts entlang der Schnittlinie und Aufaddieren der Einzelflächen entlang der Schnittlinie

7. Verfahren nach zumindest einem der Ansprüche 5 oder 6,
umfassend den Schritt:
- streckenbezogen Normieren der ersten Kenngröße und flächenbezogen Normieren der zweiten Kenngröße.

8. Verfahren nach zumindest einem der Ansprüche 5 bis 7,
umfassend den Schritt:
Bestimmen der Kenngrößen für bearbeitungs- und werkstoffspezifisch differenzierte Oberflächenstrukturen, wobei das Gesamtprofil in ein werkstoffspezifisches Porenprofil und in ein Bearbeitungsprofil separiert wird.

9. Verfahren nach Anspruch 8,
wobei die Differenzierung von Oberflächenstrukturen eines mit zumindest einem Oberflächenbearbeitungsverfahren bearbeiteten technischen Werkstoffs erfolgt, der werkstoffinhärente Oberflächenrauhigkeiten aufweist,
umfassend die Schritte:
- mit einem Profiltiefenbestimmungsverfahren Erfassen der Gesamtheit der Oberflächenstrukturen zumindest eines vorbestimmten Abschnitts der Oberfläche des oberflächenbearbeiteten technischen Werkstoffs und Darstellen als Gesamtprofil, wobei das Gesamtprofil als Datensatz von entlang einer Schnittlinie erhaltenen Profiltiefenwerten um eine vorbestimmte Mess-Grundlinie, die jeweils einer Position entlang der Länge der Mess-Grundlinie zugeordnet werden, aufgenommen wird,
- mit einem Profiltiefenbestimmungsverfahren Erfassen der Gesamtheit der Oberflächenstrukturen zumindest eines vorbestimmten Abschnitts der Oberfläche eines oberflächenbearbeiteten technischen Werkstoffs, der keine werkstoffinhärenten Oberflächenrauhigkeiten aufweist, und Darstellen als Bearbeitungsprofil, wobei das Bearbeitungsprofil als Datensatz von entlang einer Schnittlinie erhaltenen Profiltiefenwerten um eine vorbestimmte Mess-Grundlinie, die jeweils einer Position entlang der Länge der Mess-Grundlinie zugeordnet werden, aufgenommen wird und
- Ermitteln einer für das Oberflächenbearbeitungsverfahren charakteristischen Schiefe der Häufigkeitsverteilung aller Bearbeitungsprofil-Tiefenwerte, und Definieren dieser Schiefe als Soll-Schiefe für das Oberflächenbearbeitungsverfahren,
- dann Definieren einer Start-Linie in dem Gesamtprofil, die parallel zu der Mess-Grundlinie des Gesamtprofils entsprechend dem tiefsten Profiltiefenwert verläuft,
- Ermitteln einer ersten Schiefe der Häufigkeitsverteilung der von der Startlinie tangierten Profiltiefenwerte des Gesamtprofils an der Startlinie und
- Definieren schrittweise voneinander beabstandeter Zwischenlinien zwischen der Start-Linie und der Mess-Grundlinie, dann
- ausgehend von der Startlinie sukzessive Ermitteln der Schiefen der Häufigkeitsverteilungen der von der entsprechenden Zwischenlinie tangierten Profiltiefenwerte des Gesamtprofils,
- sukzessive Vergleichen aller der Schiefen von der Startlinie ausgehend mit der Sollschiefe,
- bei Übereinstimmen der Schiefe einer bestimmten Zwischenlinie des Gesamtprofils mit der Soll-Schiefe Selektieren aller Profiltiefenwerte, die die bestimmte Zwischenlinie tangieren und
- Darstellen der selektierten Profiltiefenwerte als ein Porenprofil, dabei Separieren des Bearbeitungsprofils aus dem Gesamtprofil.

10. Verfahren nach Anspruch 9,
umfassend den Schritt
- zusammenhängend Darstellen des Porenprofils der selektierten Profiltiefenwerte und in einem von dem Maßstab der Messstrecke des Gesamtprofils abweichenden Maßstab, bevorzugt einem vergrößerten Maßstab;
wobei bevorzugt die Beabstandung der Zwischenlinien voneinander und zu der Start-Linie und der Mess-Grundlinie, im Bereich von 1 nm bis 20 nm, besonders bevorzugt im Bereich von 5 nm bis 15 nm, am meisten bevorzugt bei 10 nm liegt.

## Claims

1. Thermally coated component,
having a friction-optimised surface of a runway for a friction partner, **characterised in that**
the friction-optimised surface has an oil holding volume V_{Öl} of 10 to 800 µm³/mm².

2. Thermally coated component according to claim 1,
**characterised in that**
the friction-optimised surface is mechanically treated, preferably machined and most preferably honed.

3. Thermally coated component according to one or more of claims 1 to 2,
**characterised in that**
the thermal coating is a thermal spray coating, preferably a coating produced by wire arc spraying or by plasma transferred wire arc spray coating.

4. Thermally coated component according to one or more of claims 1 to 3,
**characterised in that**
the component is a cylinder block or a piston, preferably a connection rod, or a sleeve, preferably a cylinder liner.

5. Method for the component coating surface simulation of a thermally coated component having a friction-optimised surface of a runway for a friction partner,
comprising the parameter determination for surface structures of the component coating surface, a parameter simulating a function between the component coating surface and the friction partner,
comprising the steps of:
- collecting the totality of the surface structures of at least a predetermined section of the surface of the component as an overall profile using a profile depth determination method, wherein the overall profile is recorded as a data set of profile depth values obtained along a line of cut around a predetermined measurement base line, each of which values is assigned to a position along the length of the measurement base line, and
- applying a mathematically morphological calculation programme to the data set of the overall profile, involving the simulation of the rolling of a circle with a defined radius on the overall profile and the obtaining of a rolling line (L_{KR}, L_{DS}) over the overall profile for the simulation of a contour development of the friction partner on the component coating surface,
- calculating a total area bounded by the rolling line (L_{KR}, L_{DS}) and the overall profile, and
- determining the total area as a first parameter,
- projecting the total area into the third dimension with reference to the component coating surface, and
- calculating a total volume as a second parameter,
- specifying the first parameter as a measure for the oil quantity relevant for lubrication, and
- specifying the second parameter as a theoretical oil holding volume of the component coating surface.

6. Method according to claim 5,
wherein the calculation of the total area comprises:
- for each profile depth value, determining a difference from the rolling line and an individual area between each profile depth value and a corresponding section of the rolling line (L_{KR}, L_{DS}) as a function of the position of the profile depth value along the line of cut, and adding up the individual areas along the line of cut.

7. Method according to one or more of claims 5 and 6,
comprising the step of:
- distance-related normalising of the first parameter and area-related normalising of the second parameter.

8. Method according to one or more of claims 5 to 7,
comprising the step of:
- determining the parameters for machining- and material-specifically differentiated surface structures, wherein the overall profile is split into a material-specific pore profile and a machining profile.

9. Method according to claim 8,
wherein the surface structures of an engineering material machined by means of at least one surface machining method and having material-inherent surface roughnesses are differentiated, the differentiation comprising the step of:
- collecting the totality of the surface structures of at least a predetermined section of the surface of the surface-machined engineering material using a profile depth determination method and presenting them as an overall profile, wherein the overall profile is recorded as a data set of profile depth values obtained along a line of cut around a predetermined measurement base line, each of which values is assigned to a position along the length of the measurement base line,
- collecting the totality of the surface structures of at least a predetermined section of the surface of a surface-machined engineering material having no material-inherent surface roughnesses using a profile depth determination method and presenting them as a machining profile, wherein the machining profile is recorded as a data set of profile depth values obtained along a line of cut around a predetermined measurement base line, each of which values is assigned to a position along the length of the measurement base line, and
- determining a skewness of the frequency distribution of all machining profile depth values which is typical for the surface machining method and defining this skewness as set skewness for the surface machining method,
- then defining a starting line in the overall profile which runs parallel to the measurement base line of the overall profile corresponding to the deepest profile depth value,
- determining a first skewness of the frequency distribution of the profile depth values of the overall profile to which the starting line is tangent, and
- defining incrementally stepped intermediate lines between the starting line and the measurement base line,
- then, starting from the starting line, successively determining the skewnesses of the frequency distributions of the profile depth values of the overall profile to which the respective intermediate line is tangent,
- successively comparing all of the skewnesses to the set skewness, starting from the starting line,
- if the skewness of a defined intermediate line of the overall profile matches the set skewness, selecting all profile depth values which are tangent to the defined intermediate line, and
- presenting the selected profile depth values as a pore profile while separating the machining profile from the overall profile.

10. Method according to claim 9,
comprising the step of:
- coherently representing the pore profile of the selected profile depth values in a scale deviating from the scale of the measuring distance of the overall profile, preferably an enlarged scale,
- wherein the mutual spacing of the intermediate lines and their distance from the starting line and the measurement base line preferably lies in the range of 1 nm to 20 nm, particularly preferably in the range of 5 nm to 15 nm, being most preferably around 10 nm.

## Revendications

1. Composant à revêtement thermique, qui comprend une surface à frottement optimisé d'une bande de glissement pour un partenaire de frottement, **caractérisé en ce que** la surface à frottement optimisé présente un volume huileux compris entre 10 bis 800 µm³/mm².

2. Composant à revêtement thermique selon la revendication 1, **caractérisé en ce que** la surface à frottement optimisé est traitée mécaniquement, de préférence est traitée par enlèvement de copeaux, de préférence encore par rodage à la pierre.

3. Composant à revêtement thermique selon au moins l'une des revendications 1 ou 2, **caractérisé en ce que** le revêtement thermique est une couche thermopulvérisée, de préférence une couche appliquée par projection à l'arc électrique ou une couche obtenue par revêtement par projection à l'arc électrique de plasma.

4. Composant à revêtement thermique selon au moins l'une des revendications 1 ou 3, **caractérisé en ce que** le composant est un bloc moteur ou un piston, de préférence une bielle ou un manchon, de préférence une chemise de cylindre.

5. Procédé destiné à la simulation de surfaces d'un composant à revêtement thermique qui présente une surface à frottement optimisé d'une bande de glissement pour un partenaire de frottement, consistant à déterminer la grandeur caractéristique pour les structures de surface du revêtement du composant, une grandeur caractéristique simulant une fonction entre la surface de revêtement de composant et le partenaire de frottement, comprenant les étapes consistant à :
- selon un procédé de détermination de profondeur de profilé définir la totalité des structures de surface au moins d'une section prédéfinie de la surface du composant et représenter en tant que profilé total, le profilé total étant enregistré en tant qu'ensemble de données des valeurs de profondeur de profilé obtenues le long d'une ligne de coupe autour d'une ligne de base de mesure prédéfinie qui respectivement sont associées à une position dans le sens de la longueur de la ligne de base de mesure, et
- utiliser un programme de calcul morphologique et mathématique sur l'ensemble de données du profilé total, permettant la simulation du déploiement d'un cercle présentant un rayon défini sur la profilé total et d'obtenir une ligne de déploiement (L_{KR}, L_{DS}) sur le profilé total qui simule un déroulement de contour du partenaire de frottement sur la surface de revêtement de composant,
- calculer une surface totale délimitée entre la ligne de déploiement (L_{KR}, L_{DS}) et le profilé total, et
- définir la surface totale en tant qu'une première grandeur caractéristique,
- projeter la surface totale en trois dimensions par rapport à la surface de revêtement de composant et
- calculer un volume total en tant qu'une seconde grandeur caractéristique,
- indiquer la première grandeur caractéristique en tant qu'une mesure pour la quantité d'huile nécessaire à la lubrification et
- indiquer la seconde grandeur caractéristique en tant qu'un volume huileux théorique de la surface de revêtement de composant

6. Procédé selon la revendication 5, le calcul de la surface totale consistant à :
- pour chaque valeur de profondeur de profilé déterminer une différence par rapport à la ligne de déploiement et une surface séparée entre chaque valeur de profondeur de profilé et une section correspondante de la ligne de déploiement (L_{KR}, L_{DS}) en tant que fonction de la position de la valeur de profondeur de profilé le long de la ligne de coupe et additionner les surfaces séparées le long de la ligne de coupe.

7. Procédé selon au moins l'une quelconque des revendications 5 ou 6, comprenant l'étape suivante consistant à :
- réduire en fonction du parcours la première grandeur caractéristique et réduire en fonction de la surface la seconde grandeur caractéristique.

8. Procédé selon au moins l'une des revendications 5 à 7, comprenant l'étape consistant à :
déterminer les grandeurs caractéristiques pour les structures de surfaces différenciées spécifiquement par l'usinage et la matière, le profil total étant séparé dans un profil de pores spécifiques à la matière et dans un profil d'usinage.

9. Procédé selon la revendication 8, la différentiation des structures de surface d'une matière technique usinée selon au moins un procédé de traitement de surface, ladite matière présentant une rugosité de surface inhérente, comprenant les étapes consistant à :
- déterminer selon un procédé de détermination de profondeur de profil la totalité des structures de surface d'au moins une section prédéfinie de la surface de la matière technique dont la surface a été usinée et présenter en tant que profil total, le profil total étant enregistré en tant qu'ensemble de données des valeurs de profondeur de profil obtenues le long d'une ligne de coupe autour d'une ligne de base de mesure prédéfinie qui respectivement sont associées à une position dans le sens de la longueur de la ligne de base de mesure,
- déterminer selon un procédé de détermination de profondeur de profil la totalité des structures de surface d'au moins une section prédéfinie de la surface de la matière technique dont la surface a été usinée qui ne présente aucune rugosité de surface inhérente et présenter en tant que profil d'usinage, le profil total étant enregistré en tant qu'ensemble de données des valeurs de profondeur de profil obtenues le long d'une ligne de coupe autour d'une ligne de base de mesure prédéfinie qui respectivement sont associées à une position dans le sens de la longueur de la ligne de base de mesure, et
- déterminer pour une inclinaison caractéristique au procédé d'usinage de surface de la distribution de toutes les valeurs de profondeur de profilé d'usinage et définir ladite inclinaison en tant qu'inclinaison théorique pour le procédé d'usinage de surface,
- ensuite définir une ligne de début dans le profil total, qui s'étend parallèlement à la ligne de base de mesure du profil total conformément à la valeur de profondeur de profil la plus profonde,
- déterminer une première inclinaison de la distribution des valeurs de profondeur de profil tangentes de la ligne de début du profil total sur la ligne de début et
- définir par étapes des lignes intermédiaires espacées entre elles entre la ligne de début et la ligne de base de mesure, ensuite
- à partir de la ligne de début déterminer successivement les inclinaisons des distributions des valeurs de profondeur de profilé tangentes des lignes intermédiaires correspondantes du profil total,
- comparer successivement toutes les inclinaisons à partir de la ligne de début à l'inclinaison théorique,
- en cas de coïncidence de l'inclinaison d'une ligne intermédiaire définie du profil total avec l'inclinaison théorique, sélectionner toutes les valeurs de profondeur de profil qui sont tangentes par rapport à la ligne intermédiaire définie et
- représenter les valeurs de profondeur de profil sélectionnées en tant que profil de pores, en séparant le profil d'usinage du profil total.

10. Procédé selon la revendication 9, comprenant l'étape consistant à :
- représenter de manière cohérente le profil de pores des valeurs de profondeur de profil sélectionnées et à une échelle différente de l'échelle du trajet de mesure du profil total, de préférence dans une échelle agrandie, de préférence la distance entre les lignes intermédiaires entre elles et par rapport à la ligne de début et de la ligne de base de mesure, se trouve dans une plage comprise entre 1 nm et 20 nm, de préférence encore dans une plage comprise entre 5 nm et 15 nm, mieux encore à 10 nm.
